(19) **Europäisches Patentamt / European Patent Office / Office européen des brevets**

(11) **EP 2 771 913 B1**

(12) **EUROPÄISCHE PATENTSCHRIFT**

(45) Veröffentlichungstag und Bekanntmachung des Hinweises auf die Patenterteilung:
**20.12.2017 Patentblatt 2017/51**

(21) Anmeldenummer: **12759361.4**

(22) Anmeldetag: **16.08.2012**

(51) Int Cl.:
*H01L 31/042* (2014.01)   *F24J 2/52* (2006.01)

(86) Internationale Anmeldenummer:
**PCT/EP2012/003473**

(87) Internationale Veröffentlichungsnummer:
**WO 2013/060400 (02.05.2013 Gazette 2013/18)**

(54) **HALTERUNGSSYSTEM ZUR MONTAGE EINES PHOTOVOLTAIKMODULS**

RETAINING SYSTEM FOR INSTALLING A PHOTOVOLTAIC MODULE

SYSTÈME DE FIXATION DESTINÉ AU MONTAGE D'UN MODULE PHOTOVOLTAÏQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **26.10.2011 DE 102011116926**
**20.04.2012 DE 102012008001**

(43) Veröffentlichungstag der Anmeldung:
**03.09.2014 Patentblatt 2014/36**

(73) Patentinhaber: **Adensis GmbH**
**01129 Dresden (DE)**

(72) Erfinder:
• **BECK, Bernhard**
**97332 Volkach**
**OT Dimbach (DE)**
• **SCHOLLER, Michael**
**97318 Kitzingen (DE)**
• **SIEDLER, Thomas**
**97228 Rottendorf (DE)**

(56) Entgegenhaltungen:
**DE-A1- 2 758 067    DE-A1-102009 003 151**
**DE-U1-202008 003 148    DE-U1-202011 050 810**
**US-A- 5 143 556**

**Beschreibung**

Die Erfindung betrifft ein Halterungssystem zur Montage eines Photovoltaikmoduls auf einem Untergrund mittels Bodenstützen, die einen Auflagekopf, einen Bodenstützenkörper und eine untergrundseitige Auflagefläche aufweisen, die einem Eindringen der Bodenstützen in den Untergrund entgegenwirkt.

US 5,143,556 A1 offenbart ein Halterungssystem gemäß dem Oberbegriff des Anspruchs 1. Bei der Konstruktion von Photovoltaik-Freiflächenanlagen wird in der Regel ein Traggerüst für die Vielzahl von Photovoltaikmodulen (PV-Module) errichtet, welches aus Stützen unterschiedlicher Länge besteht. Auf den Stützen sind Querbalken angeordnet, die sich über die Stützen jeweils gleicher Länge erstrecken. Wiederum quer zu den Querbalken ist eine Vielzahl von parallel angeordneten Holmen in einem Rastermaß angeordnet, welches an die Länge oder Breite der PV-Module angepasst ist. Auf den Holmen werden mittels Klammern die gerahmten oder nicht gerahmten PV-Module befestigt.

Die vergleichsweise kurzen Stützen weisen eine Länge von ca. 0,8 Meter bis 1,1 Meter auf, und die vergleichsweise langen Stützen können Längen von 1,5 Meter bis zu 3 Metern oder mehr annehmen. Stützen der bekannten Längen erfordern eine sichere Verankerung im Boden bzw. im Untergrund, was wiederum zusätzliche Kosten in Form von Rammarbeiten oder der Einbringung von Fundamenten verursacht. Die vergleichsweise langen, hohen Stützen bieten den Vorteil, dass die PV-Module während der Montage von unten relativ komfortabel frei zugänglich sind. Dies ist insbesondere auch für die spätere Pflege des Geländes wichtig, auf dem die Photovoltaikanlage steht. Aus Gründen des Umweltschutzes ist dies in der Regel eine begrünte Fläche, die im Sommer regelmäßig gemäht werden muss.

Während in der Vergangenheit der Anteil der Stahl- und/oder Holzkonstruktion des Gerüstes an den Anlagenkosten ca. 10% betragen hat, ist derzeit ein Anteil an den Gesamtkosten von 20% bis 30% für die Unterkonstruktion anzusetzen.

Der Erfindung liegt daher die Aufgabe zugrunde, eine konstruktiv einfache und kostengünstige Unterkonstruktion für eine PV-Freiflächenanlage anzugeben, die insbesondere für eine Bauweise geringer Höhe geeignet ist.

Diese Aufgabe wird erfindungsgemäß gelöst durch die Merkmale des Anspruchs 1. Vorteilhafte Ausgestaltungen und Weiterbildungen sind Gegenstand der Unteransprüche.

Hierzu ist vorgesehen, dass die Bodenstützen kopfseitig eine in einem Neigungswinkel gegen den Untergrund schräg gestellte Auflageplatte aufweisen, und dass die Bodenstützen dazu vorgesehen und eingerichtet sind, dass im Montagezustand die Auflageplatten eines Bodenstützenpaares zum Untergrund zueinander vertikal und in Anpassung an das vorzugsweise gerahmte Photovoltaikmodul zueinander horizontal beabstandet sind sowie miteinander zumindest im Wesentlichen fluchten. Dadurch ist eine einfache und materialsparende Anordnung auch für geringe Montagehöhen bereitgestellt, die durch eine erforderliche Anzahl von Stützenpaaren mit jeweils zwei freistehenden Bodenstützen gekennzeichnet ist.

Der Erfindung geht von der Überlegung aus, dass aufgrund moderner Robotertechnik automatische Rasenmäher verfügbar sind, die selbstständig Rasenflächen mähen und dabei Hindernissen ausweichen und somit auch bei PV-Anlage mit einer Vielzahl von Bodenstützen einsetzbar sind, zwischen denen ein begraster Untergrund gemäht und somit zuverlässige gepflegt werden kann.

Die Auflageplatten sind mittels einer Anbindung mit den Bodenstützen montagetechnisch gekoppelt. Für die Anbindung ist es beispielsweise denkbar, dass die Bodenstützen eine Gewindebohrung im Bereich ihres Auflagekopfes aufweisen, und die Auflageflächen entweder direkt oder mittels einer gelenkartigen Anbindungsstruktur in die Gewindebohrung einschraubbar sind. Durch die Trennung von Stützelement und Auflageplatte bzw. Auflagefläche ist es vorteilhaft und einfach ermöglicht, einerseits die Stützelemente möglichst einheitlich und einfach herzustellen, und andererseits durch Austausch oder Variation der Auflageplatten beziehungsweise deren Neigung eine möglichst hohe Flexibilität bei der Montage der PV-Module zu erreichen. Dadurch ist eine besonders kostengünstige und zeitsparende Montage auch großflächiger PV-Anlagen ermöglicht.

In einer geeigneten Ausführung ist der Bodenstützenkörper durch ein Trägerelement gebildet, welches einen insbesondere U-förmigen Querschnitt aufweist. In dieser Ausführung ist der horizontale U-Schenkel beispielsweise als Auflageplatte ausgeführt. Durch den U-förmigen Querschnitt ist diese Ausführung einerseits stabil und andererseits materialsparend. Diese Ausführungsvariante ist besonders vorteilhaft für PV-Anlagen, die auf relativ weichen Flachdächern beziehungsweise Bitumendächern montiert werden.

In einer ebenso geeigneten alternativen Ausführung ist der Bodenstützenkörper ein Stab. In dieser Ausführung sind die Bodenstützen insbesondere in den Untergrund einrammbare Stützpfosten, die gegenüber den in allen Richtungen einwirkenden Windlasten eine besonders hohe Standsicherheit gewährleisten. Die Stützpfosten können beispielsweise als ein Spritzgussteil aus Kunststoff oder als Gussteil aus einem Metall gefertigt sein. Die Stützpfosten können weiterhin beispielsweise hohlzylinderartig aufgebaut sein, um die Materialkosten weiter zu reduzieren.

In einer bevorzugten Weiterbildung sind im Montagezustand die Anbindungsstellen zwischen der jeweiligen Auflageplatte und dem jeweiligen Bodenstützenkörpers einer ersten Bodenstütze und der zweiten Bodenstütze des Bodenstützenpaares gemäß der Beziehung

$$a_{v2} = a_{v1} + a_h \cdot \tan \alpha$$

beabstandet. Hierbei ist $\alpha$ der Neigungswinkel, $a_{v1}$ der vergleichsweise geringe vertikale Abstand der Anbindungsstelle der ersten Bodenstütze zum Untergrund, $a_{v2}$ der vergleichsweise große vertikale Abstand der Anbindungsstellen der zweiten Bodenstütze zum Untergrund und $a_h$ der horizontale Abstand zwischen den Anbindungsstellen des Bodenstützenpaares.

Durch die einfache geometrische Beziehung ist sichergestellt, dass die PV-Module stets in einer möglichst niedrigen Montagehöhe sowie in der richtigen Position und Ausrichtung montierbar sind. So ist es beispielsweise möglich, dass bei einer Montagestelle der horizontale Abstand zwischen den Anbindungsstellen des Bodenstützpaares (Stützelementpaares) variiert werden muss, beispielsweise zur Montage von größeren und/oder mehreren PV-Modulen, was durch eine entsprechende Anpassung eines oder beider vertikalen Abstände korrigiert werden kann. Hierdurch erhöht sich vorteilhaft die Flexibilität des Haltesystems.

Der Winkel $\alpha$ dient nicht nur zur Einstellung einer günstigen Neigung und Ausrichtung der PV-Module zur Sonne, sondern soll vielmehr sicherstellen, dass eine Selbstreinigung der Module durch Regen und gegebenenfalls ein Abgleiten einer Schneedecke stattfinden. Die unterschiedlichen Höhen, auf denen sich die Auflageplatten nach der Montage befinden, können beispielsweise über ein unterschiedlich tiefes Einrammen der ersten Bodenstütze im Vergleich zur zweiten Bodenstütze erreicht werden.

Unter einer Auflageplatte wird dabei jedes Aufnahmeelement verstanden, dass für ein Aufliegen des Rahmens des gerahmten Moduls geeignet ist. Dies kann insbesondere ein vorzugsweise galvanisiertes Blech sein oder auch ein Drahtgerüst, eine geformte Kunststoffplatte oder ein Rahmen aus Profilleisten. Wichtig ist, dass die Auflageplatte zwei Abkantungen oder geeignet abgewinkelte oder abgebogene Teile umfasst, auf denen die Modulrahmen unter einem vorgebbaren Winkel zum Untergrund montiert werden können.

Gemäß einer alternativen Ausführungsform ist der Bodenstützenkörper ein Stab. Ist die Untergrundfläche in zweckmäßiger Ausgestaltung ein Teller, so ist an dessen Unterseite geeigneterweise ein in den Untergrund eintreibbarer Dorn angeordnet, insbesondere in Form einer zugespitzten Verlängerung des Stabes. Unter einem Teller wird eine konstruktive Maßnahme verstanden, die ein ungehindertes Eindringen des Stabes in den Untergrund verhindert. Es kann also ein flächiges Blech oder eine Betonscheibe oder allgemein ein Bauteil sein, das flügelartige Stege nach Art eines Skistockes aufweist und ein ungewünschtes oder ungewollt tiefes Eindringen in den Untergrund verhindert. Unter einem Stab wird ein längliches Bauteil verstanden, wie z. B. eine massive Stange, ein Vierkantrohr oder ein Rundrohr, das geeignet ist, den Teller starr mit der Auflageplatte zu verbinden.

Unter Abkantung wird jede Art von Richtungsänderung der Fläche der Auflageplatte verstanden. Eine nach oben weisende Abkantung hat dabei eine schräg aufwärts verlaufende Fläche. Eine nach unten weisende Abkantung hat eine schräg abwärts verlaufende Fläche zur Folge. Die Abkantung selbst kann eine klare Kante oder eine Rundung oder jede andere geeignete Form sein, die die gewünschte Richtungsänderung der Auflageplatte zur Folge hat. Dabei kann auch ein zusätzliches Bauteil, beispielsweise ein angesetzter Blechstreifen, eingesetzt werden.

Die erfindungsgemäßen Maßnahmen bieten insbesondere den Vorteil, dass schwere Bauelemente der klassischen Unterkonstruktionen wie Stützen, Querbalken und Holme entfallen und ersetzt werden durch eine Vielzahl von leichten und besonders handlichen Bodenstützen.

Dies ermöglicht es, den Abstand zwischen der Auflagefläche und der Auflageplatte zwischen 30cm und 100cm, insbesondere zwischen 40cm und 80cm, und besonders bevorzugt zwischen 50cm und 60cm auszulegen. Die Stützen für die PV-Module sind damit im Vergleich zum Stand der Technik relativ kurz, was den Materialaufwand verringert. Durch die geringe Bauhöhe kann auftretender Wind die Unterkonstruktion nicht derart unterfahren und entsprechend hohe Auftriebskräfte unter den PV-Modulen erzeugen, wie es bei vergleichsweise hoch platzierten PV-Modulen der Fall ist. Die PV-Module bieten daher kaum Angriffsfläche für Wind.

Daher ist es ausreichend, dass die Auflagefläche als ein Teller ausgeführt ist, wobei an der Unterseite des Tellers ein in das Gelände eintreibbarer Dorn angeordnet ist, der insbesondere durch eine zugespitzte Verlängerung des Stabes gebildet wird. Der Dom verhindert ein laterales Verrutschen der Bodenstütze und bietet zugleich einen Beitrag, einer durch Wind bedingten Auftriebskraft entgegen zu wirken. Der Auftriebskraft wird aber im Wesentlichen durch das Eigengewicht der montierten PV-Module begegnet, das ein Abheben der Bodenstütze vom Gelände verhindert.

Zusätzlich oder alternativ zum Dorn kann die Unterseite der Auflagefläche mit einer Antirutschstruktur versehen sein, wobei dann auf den Tellern ein Belastungsgewicht vorgesehen sein sollte. Das Belastungsgewicht kann auch nur in Zusammenhang mit dem Dorn ohne Antirutschstruktur vorgesehen sein, falls das Eigengewicht der PV-Module nicht ausreicht, um zusammen mit dem Rückhalteeffekt des Dorns größer als die zu erwartenden Auftriebskräfte zu sein. Als Antirutschstruktur kommt zum Beispiel eine geriffelte Unterseite der Teller, eine Unterseite mit Spikes oder dergleichen infrage.

Um die Bodenstützen konstruktiv möglichst einfach und kostengünstig zu gestalten, ist es vorteilhaft, wenn der Stab rund ist und zumindest im oberen Teilbereich ein Außengewinde aufweist, welches mit einem zentralen Loch mit Innengewinde fluchtet, welches zwischen den jeweils gegenüberliegenden Abkantungen der Auflageplatte angeordnet ist. Der Zwischenteil zwischen den Abkantungen der Auflageplatte ist dabei im Montagezustand im Wesentlichen parallel zum Gelände angeordnet, so dass der Stab in Richtung der Normalen bezüglich des horizontalen Zwischenteils der Auflageplatte weist. Das gleiche gilt für den unteren Teilbereich des Stabes, der ebenfalls zumindest dort ein Außengewinde aufweist, welches mit einem zentralen Loch mit Innengewinde fluchtet, welches im Zentrum des Tellers angeordnet ist. Beide Teilbereiche jeder Bodenstütze dienen dazu, auch im Anschluss an ein Planieren des Untergrunds möglicherweise verbliebene Unebenheiten im Gelände auszugleichen. Dadurch wird die Möglichkeit geschaffen, eine gleichmäßige Anordnung der PV-Module in einer Ebene (abgesehen vom beabsichtigten Winkel zum Gelände) zu erzielen.

Die unterschiedlichen Höhen der beiden Bodenstützen über Geländeniveau kann über verschieden lange Stäbe erzielt werden. Alternativ ist auch eine gleiche Länge der Stäbe möglich, wobei dann die eine Bodenstütze des Paares tiefer in den Boden eingeschlagen wird als die andere Bodenstütze des Paares. Über die Stabbereiche mit Außengewinde können dann die Niveaus des Tellers und der Auflageplatte derart eingestellt werden, dass die gewünschte Höhendifferenz zwischen den beiden Auflageplatten des Paares vorliegt.

Etwaige ungleichmäßige Absenkungen der Bodenstützten werden dadurch kompensiert, dass die Auflageplatten aus einem biegsamen Material gefertigt sind, so dass eine durch unterschiedliches Absacken der Bodenstützen in das Gelände hervorgerufene Torsion innerhalb der Auflageplatten abgefangen wird. Die Torsion kann zwar auftreten, führt jedoch gegebenenfalls nicht zu hohen mechanischen Spannungen in den Auflageplatten, da derartige Spannungen infolge des Verbiegens umgangen werden. Als biegsame Auflageplatte ist insbesondere ein Federstahlblech, eine Scheibe aus Kunststoff, wie z. B. Teflon, ein aufgrund seiner geringen Stärke biegsames Metallblech oder dergleichen geeignet.

Für die Befestigung der gerahmten PV-Module ist die durch jede Abkantung gebildete Seitenfläche mit einem Gewindeloch für die Befestigung einer Modulklammer und mit einem nach oben weisenden Zentrierstift versehen, der im montierten Zustand in eine kongruente Aussparung im Rahmen des PV-Moduls eingreift. Anstelle des Zentrierstiftes oder zusätzlich zum Zentrierstift kann auch ein Montagehilfsstift zu Anwendung kommen.

In einer geeigneten Ausführung weisen die Auflageplatten jeweils eine Haltestruktur auf, welche im Montagezustand mit einer komplementären Gegenstruktur an der Unterseite des PV-Moduls verzahnt. Die Haltestruktur und die Gegenstruktur sind in einer geeigneten Ausführungsform etwa sägezahnartig ausgeführt, sodass eine abrutschsichere Befestigung der PV-Module auf den Auflageflächen einfach und sicher realisierbar ist.

In einer geeigneten Weiterführung sind die Auflageplatten einerseits und die Unterseite der PV-Module andererseits nicht lösbar mittels eines Klebers verbunden, oder die PV-Module sind auf den Auflageplatten formschlüssig und zerstörungsfrei klemmfixierbar. Dadurch ist beispielsweise mit einem Clip-, Klett-, Schnapp- oder Druckknopfverschluss ein schnelles und werkzeugloses montieren der PV-Module ermöglicht. Eine Klebeverbindung ermöglicht eine gleichmäßigere Spannungsverteilung und Kraftübertragung auf die Eckbereiche und Kanten der PV-Module sowie eine Gewichts- und Kostenersparnis. Die Klebeverbindung kann insbesondere nach Art einer Bewegungs-, Dehn- oder Dilatationsfuge ausgeführt sein, um die Gefahr von Spannungsrissen der PV-Module aufgrund auftretender Torsionskräfte zu verringern.

In einer zweckmäßigen Ausführung weisen die Auflageplatten zum Schutz der Kanten der PV-Module und zu deren rutschsicherer Befestigung in mindestens einem Eckbereich ein Polster auf. Dadurch werden die Ecken eines montierten PV-Moduls bei Krafteinwirkung auf die Photovoltaikmoduloberfläche, beispielsweise während der Montage oder Wartung, entlastet. Das Polster ist geeigneterweise aus einem Material gefertigt, insbesondere einem elastischen Gummimaterial, welches weicher ist als das Material der Auflagefläche und/oder der Photovoltaikmodulunterseite. In einer zusätzlichen oder alternativen Ausgestaltungsform ist es beispielsweise denkbar, dass die gesamte Oberfläche der Auflageflächen zusätzlich mit einem weichen, flexiblen Material beschichtet oder belegt ist.

Für kleinflächige PV-Anlagen, wie diese beispielsweise bei Bitumendächern zum Einsatz kommen, können die Auflageflächen aus Gründen der Sturmsicherheit mit kostengünstigen Gewichten wie beispielsweise Beton beschwert sein, so dass eine kraftschlüssige Standsicherheit sichergestellt ist. Dadurch ist es nicht erforderlich, die Dachhaut zu durchbohren, wodurch Probleme hinsichtlich erforderlicher und/oder zuzusichernder Dichtheit vorteilhaft vermieden werden. Bevorzugt weist der Teller eine Gewindebohrung oder eine versenkte Mutter an der Tellerunterseite auf, in die das Gewinde der Bodenstützen einschraubbar ist. Zusätzlich oder alternativ ist es denkbar, eine Kontermutter auf der Telleroberseite anzuordnen.

In einer bevorzugten Weiterbildung ist der Rand des Tellers schalenartig nach oben gebogen. Dadurch ist eine kippbare Lagerung des Haltesystems realisiert, welche vorteilhaft und einfach die Sturmsicherheit verbessert. Hierbei wird die Betriebslage der PV-Module durch ein leichtes Übergewicht mittels der Beschwerung gehalten. Bei einer starken Windlast können sich die PV-Module durch die auftretenden Auftriebskräfte selbstständig aus dem Wind drehen bzw. neigen, wodurch ein einfacher und kostengünstiger Sturmschutz realisiert ist.

Für großflächige PV-Anlagen können die Paare von Bodenstützen auf verschiedene Weise zur Bildung eines Stützenfeldes für die Bestückung mit PV-Modulen angeordnet werden. Gemäß einer ersten bevorzugten Art ist vorgesehen, dass die ersten Bodenstützen und die zweiten Bodenstützen jeweils eine Mehrzahl von parallel zueinander verlaufenden Reihen bilden, wobei sich zwischen zwei Reihen von ersten Bodenstützen eine Reihe von zweiten Bodenstützen befindet. Die Bodenstützen von Reihen verschiedener Länge stehen sich jeweils auf gleicher Höhe gegenüber, also unmittelbar nebeneinander. So dient die Auflageplatte jeder Bodenstütze zum Abstützen von zwei gerahmten Kanten an beliebiger Stelle des Modulrandes eines PV-Moduls. Eine der abgekanteten Teilflächen dient zur Aufnahme eines ersten PV-Modulrandes und die andere Teilfläche dient zur Aufnahme eines Rahmenrandes eines benachbarten PV-Modulrandes. Der Abstand zwischen Bodenstützen gleicher Länge beträgt dann z. B. eine halbe Modulbreite, so dass zwischen zwei benachbarten Stützen etwa eine halbe Modulbreite vorliegt und links bzw. rechts von je einer der benachbarten Bodenstützen ein Viertel einer Modulbreite über die Bodenstütze herausragt. Bei dieser Anordnung der Bodenstützen ist es auch denkbar, den Abstand der Bodenstützen an die Breite des verwendeten PV-Moduls anzupassen. Dadurch kann jede Auflageplatte vier Ecken von im Viereck angeordneten PV-Modulen aufnehmen, nämlich je eine Ecke pro PV-Modul.

Die zweite bevorzugte Art der Bodenstützenanordnung sieht vor, dass die Reihen mit ersten Bodenstützen versetzt sind zu den Reihen mit zweiten Bodenstützen, so dass bei montierten PV-Modulen - mit Ausnahme der randseitigen PV-Module - jedes PV-Modul an insgesamt drei Auflageplatten befestigt ist. Die jeweils kürzeren Bodenstützen sind dabei derart angeordnet, dass der Abstand zwischen Bodenstützen gleicher Länge z. B. eine halbe Modulbreite beträgt. Somit liegt zwischen zwei benachbarten Stützen etwa eine halbe Modulbreite vor und links bzw. rechts von je einer der benachbarten Bodenstützen ragt ein Viertel einer Modulbreite über die Bodenstütze hinaus. Auch hier ist der Abstand derart wählbar, dass die untere Kante jedes PV-Moduls an seinen beiden Ecken auf eine der Bodenstützen kleinerer Länge aufliegt. Im Ergebnis wird der untere Rahmenrand von zwei Auflageplatten abgestützt. Dies ist vorteilhaft, um die höhere Last auf dem unteren Rand im Vergleich zu der Last auf dem höher liegenden Rand abzufangen.

Der Versatz der längeren Bodenstützen gegenüber den kürzeren Bodenstützen ist derart zu bemessen, dass jede Bodenstütze mit größerer Länge jeweils etwa in der Mitte eines PV-Modulrandes liegt. Dadurch wird der obere Modulrand nur von einer einzigen Bodenstütze in der Mitte des Modulrandes abgestützt. Das PV-Modul wird somit an drei Punkten abgestützt, nämlich an zwei Stützpunkten am unteren Rand und an einem Stützpunkt am oberen Rand.

Nachfolgend werden Ausführungsbeispiele der Erfindung anhand einer Zeichnung näher erläutert. Darin zeigen:

Fig. 1       perspektivisch eine erste Anordnung von Photovoltaikmodulen auf mehreren Paaren von Bodenstützen,
Fig. 1a      die Anordnung gemäß der Fig. 1 in Aufsicht,
Fig. 2       perspektivisch eine zweite Anordnung von Photovoltaikmodulen auf mehreren Paaren von Bodenstützen,
Fig. 2a      die Anordnung gemäß Fig. 2 in Aufsicht,
Fig. 3       den oberen Bereich einer ersten Bodenstütze eines Paares,
Fig. 4       den oberen Bereich einer zweiten Bodenstütze eines Paares,
Fig. 5       eine Schnittdarstellung des unteren Bereichs einer Bodenstütze in einer ersten Ausführung,
Fig. 6       in einer Darstellung gemäß Fig. 5 eine zweite Ausführung des unteren Bereichs einer Bodenstütze,
Fig. 7       in einer Darstellung gemäß Fig. 5 eine dritte Ausführung des unteren Bereichs einer Bodenstütze,,
Fig. 8       eine Schnittdarstellung eines freistehend montierten Photovoltaikmodul auf einem Untergrund,
Fig. 9       in Aufsicht eine Auflageplatte mit Polstern,
Fig. 10      perspektivisch eine Anordnung von Photovoltaikmodulen gemäß Fig.1 auf mehreren Paaren von Trägersystemen,
Fig. 10a     eine Schnittdarstellung einer ersten Bodenstütze gemäß Fig. 10,
Fig. 10b     eine Schnittdarstellung einer zweiten Bodenstütze gemäß Fig. 10, und
Fig. 11      eine Anordnung eines Montagehilfsstiftes auf einer Auflageplatte.

Einander entsprechende Teile und Größen sind in allen Figuren mit den gleichen Bezugszeichen versehen.

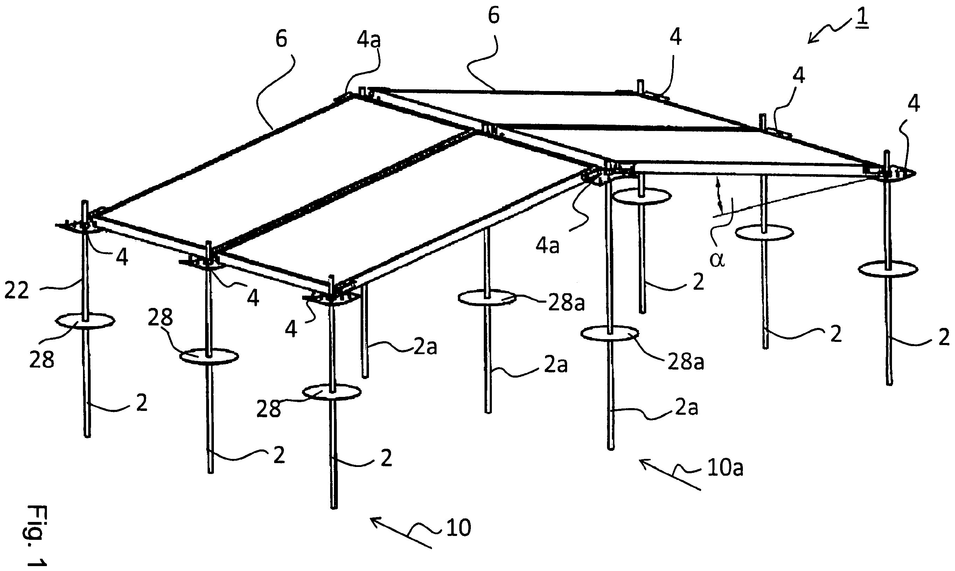

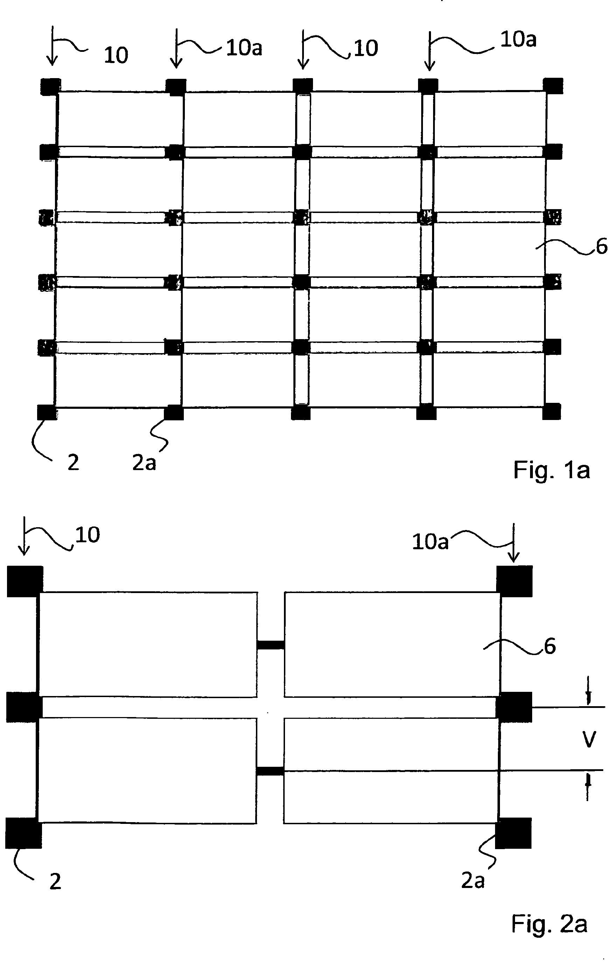

Fig. 1 zeigt eine Haltevorrichtung (Haltesystem) 1 für eine Photovoltaikanlage. In den Fig. 1 und 1a werden eine erste und eine zweite Bodenstütze 2 bzw. 2a als Paar bezeichnet. Jede Bodenstütze 2, 2a umfasst eine Auflageplatte 4, 4a für Photovoltaikmodule (PV-Module) 6. Die PV-Module 6 sind randseitig mit einem Rahmen (nicht gezeigt) versehen. Die Bodenstützen 2,2a werden auf einem Untergrund 8 derart montiert, dass deren zugehörige Auflageplatten 4, 4a auf einem unterschiedlichen Niveau und die PV-Module 6 unter einem gewünschten Winkel $\alpha$ zum Untergrund 8 ausgerichtet sind.
Im gezeigten Ausführungsbeispiel befindet sich die Auflageplatte 4 der ersten Bodenstütze 2 niedriger über dem Untergrund 8, also in geringerem vertikalen Abstand zum Untergrund 8 als die Auflageplatte 4a der zweiten Bodenstütze 2a. Der Winkel $\alpha$ dient nicht zur Einstellung einer günstigen Neigung der PV-Module 6 zur Sonne, sondern soll sicherstellen, dass eine Selbstreinigung der Module 6 durch Regen und gegebenenfalls ein Abgleiten einer Schneedecke stattfinden. Die unterschiedlichen Höhen, auf denen sich die Auflageplatten 4, 4a nach der Montage befinden können, können beispielsweise über ein unterschiedlich tiefes Einschlagen der Bodenstütze 2 im Vergleich zur Bodenstütze 2a erreicht werden.

In dieser ersten Ausführungsform stützt die jeweilige Auflageplatte 4, 4a jeweils vier Ecken von vier an den Ecken gegeneinander geführten Photovoltaikmodulen 6 ab. Bei einem vergleichsweise großen Feld bzw. einer entsprechend großen PV-Anlage von mehreren Hundert PV-Modulen 6 liegen dann im Ergebnis mehrere, durch einen ersten Pfeil 10 gekennzeichnete Reihen von ersten Bodenstützen 2 vor, die sich mit durch einen zweiten Pfeil 10a gekennzeichneten Reihen von zweiten Bodenstützen 2a abwechseln. Die an gleicher Stelle in der jeweiligen Reihe 10, 10a stehenden Bodenstützen 2, 2a stehen den Bodenstützen 2, 2a der benachbarten Reihe 10, 10a direkt gegenüber. Diese unversetzte Anordnung von Bodenstützen 2, 2a ist aus der Figur 1a vergleichsweise deutlich zu erkennen. In Fig. 1a ist beispielhaft lediglich ein Photovoltaikmodul 6, sowie ein Bodenstützenpaar 2, 2a mit Bezugszeichen versehen.

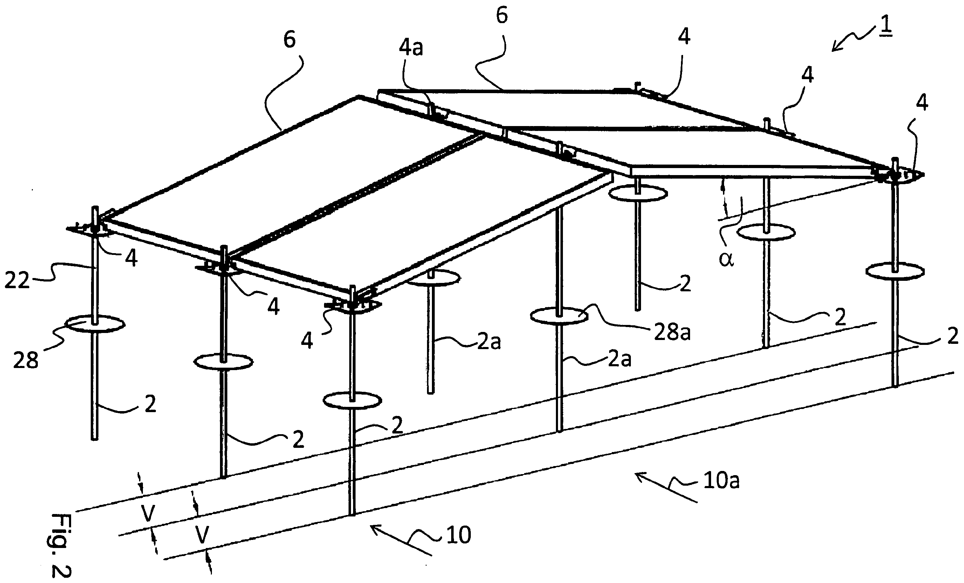

In den Fig. 2 und 2a ist eine ähnliche Anordnung mit dem Unterschied gezeigt, dass die Auflageplatten 4a der zweiten Bodenstützen 2a nicht an den Ecken der abgestützten Photovoltaikmodule 6 ansetzen, sondern in der Mitte des gerahmten Randes. Die zweiten Bodenstützen 2a sind dabei diejenigen mit der Auflageplatte 4a auf höherem Niveau. Die ersten Bodenstützen 2, deren Auflageplatten 4 auf dem tieferen Niveau angeordnet sind, sind analog zur Fig. 1 an den Ecken der Photovoltaikmodule 6 platziert. Es ergibt sich somit eine Dreipunktlagerung für jedes Photovoltaikmodul 6, die eine mechanisch weitgehend spannungsfreie Belastung für die Ecken der Glasscheiben der Photovoltaikmodule 6 bei z. B. ungleich verteilter Schneelast mit sich bringt.

Im Ergebnis liegen wiederum zwei Arten von Reihen 10, 10a an ersten bzw. zweiten Bodenstützen 2, 2a mit unterschiedlich gerichteten Abkantungen vor, wie nachfolgend anhand der Fig.ren 3 und 4 näher erläutert, die parallel zueinander verlaufen. Abweichend von der Anordnung gemäß Fig. 1 liegen die Bodenstützen 2 an gleicher Stelle in einer Reihe 10 nicht den Bodenstützen 2a der benachbarten Reihe 2a gegenüber. Es liegt also ein Versatz V vor, der im Wesentlichen der halben Breite eines Photovoltaikmoduls 6 entspricht.

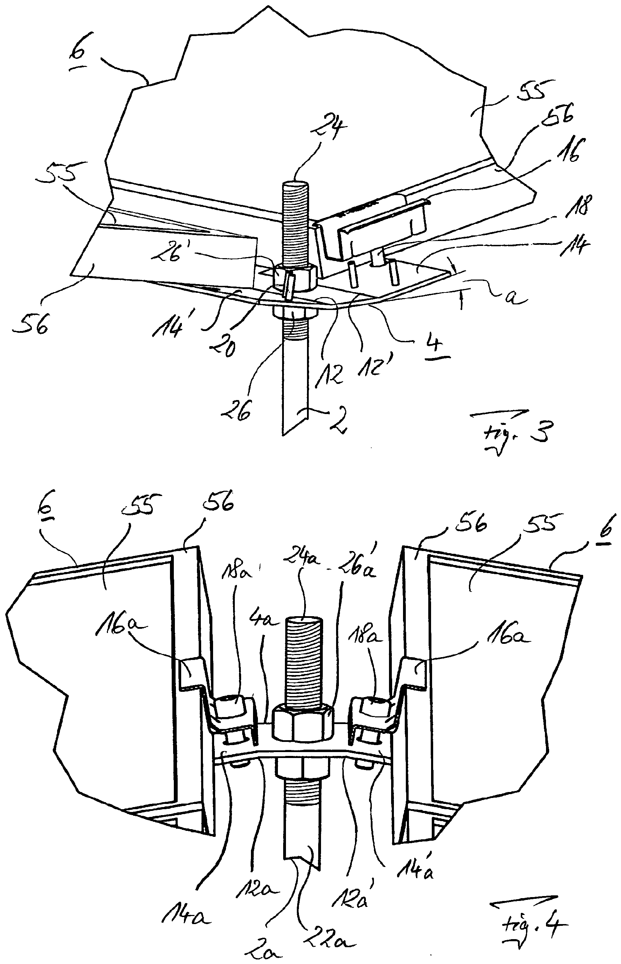

In Fig. 3 ist der obere Bereich der ersten Bodenstütze 2 mit seiner Auflageplatte 4 gezeigt. Die Auflageplatte 4 weist zwei Abkantungen 12, 12' auf, durch welche bei der Auflageplatte 4 zwei Auflageflächen 14, 14' gebildet werden. Die Abkantungen 12, 12' sind nach oben gerichtet, das heißt, dass auch die Auflageflächen 14, 14' nach oben weisen, vorzugsweise mit dem Winkel $\alpha$ zur Horizontalen, der die gewünschte Neigung der Photovoltaikmodule 6 zum Untergrund 8 festlegt.

Die Auflageplatte 4 der gezeigten Bodenstütze 2 ist für die Abstützung von jeweils einer Ecke von vier aneinandergrenzenden Photovoltaikmodulen 6 ausgeführt, von denen die hinteren zwei eingezeichnet sind. Zu deren Befestigung dienen zwei Modulklammern 16, die jeweils das Verklemmen von zwei Photovoltaikmodulen 6 übernehmen. Jede Modulklammer 16 weist in deren Grund oder Boden eine Bohrung auf (nicht sichtbar) durch welche eine Schraube 18 oder ein Gewindestift mit der Auflagefläche 14 fest verbunden werden kann, um die Modulklammer 16 an der Auflagefläche 14, 14' zu fixieren. Für diese Befestigung ist die Auflageplatte 4 vorzugsweise mit zwei Einnietmuttern versehen, von denen jeweils eine etwa im Zentrum der jeweiligen Auflagefläche 14, 14' angeordnet ist. Anstelle der Einnietmuttern kann auch ein Loch mit Innengewinde vorgesehen sein, in welches die Schraube 18 eindrehbar und verspannbar ist.

Für die Lagefixierung jedes Photovoltaikmoduls 6 auf der Bodenstütze 2 sind jeweils zwei Zentrierstifte 20 vorgesehen. Von den insgesamt acht Zentrierstiften 20 sind vier in Fig: 3 unsichtbar, da diese von den bereits montiert gezeigten Photovoltaikmodulen 6 verdeckt werden. Die vier sichtbaren Zentrierstifte 20 sind für die beiden vorderen, noch zu montierenden Photovoltaikmodule 6 vorgesehen.

Die ersten Bodenstützen 2 weisen jeweils einen Stab 22 auf, der eine Gewindestange sein kann oder aber zumindest in seinem oberen Bereich mit einem Außengewinde 24 versehen ist. Auf dem Außengewinde 24 sind zwei Muttern 26, 26' vorgesehen, wobei die erste Mutter 26 unterhalb der Auflageplatte 4 angeordnet ist und diese gegen ein Verrutschen nach unten sichert. Die obere Mutter 26' verspannt zusammen mit der unteren Mutter 26 die Auflageplatte 4 fest am Stab 22.

Fig. 4 zeigt einen Typ der zweiten Bodenstütze 2a, wie diese für die Anordnung in der Mitte des gerahmten Randes des Photovoltaikmoduls 6 vorzusehen ist. Gleiche Teile sind mit dem Zusatz "a" zur Kenntlichmachung versehen, das es sich um die zweite Bodenstütze 2a handelt. Die zweite Bodenstütze 2a ist diejenige, deren Auflageplatte 4a auf einem höheren Niveau liegt als die Auflageplatte 4 der ersten n Bodenstützen 2. Entsprechend sind in Abänderung zu der in Fig. 3 gezeigten Bodenstütze 2 die Abkantungen 12a, 12a' bei der zweiten Bodenstütze 2a unter dem Winkel $\alpha$ nach unten gerichtet. Die durch die Abkantungen 12a, 12a' gebildeten Auflageflächen 14a und 14a' weisen also nach unten hin zu den komplementären Auflageflächen 14, 14' der ersten Bodenstütze 2, so dass alle Auflageflächen 14, 14a, die dasselbe Photovoltaikmodul 6 halten, in einer gemeinsamen Ebene liegen.

Auch bei den Auflageplatten 4a der zweiten Bodenstütze 2a ist ein entsprechender Zentrierstift 20 vorgesehen, um das Photovoltaikmodul 6 in eine ausgerichtete Position zu halten. Die Modulklammern 16 sind aus Gründen der Massenfertigung dieselben, wie die für die Vier-Ecken-Befestigung nach der Fig. 3. Aus Gründen der Kostenersparnis kann es gegebenenfalls zweckmäßig sein, den nicht benutzen Steg, der ansonsten für das Verklemmen eines weiteren Moduls 6 dient, wegzulassen, da dieser bei der hier vorliegenden mittigen Positionierung der Klammer 16 am Modulrand nicht benötigt wird.

Im Ergebnis sind bei der ersten Bodenstütze 2 des Paares die zugehörige Auflageplatte 4 mit zwei sich gegenüberliegenden und nach oben abgekanteten Auflageflächen 14, 14' versehen, und bei der zweiten Bodenstütze 2a des Paares sind die Auflageplatte 4a mit zwei sich gegenüberliegenden und nach unten abgekanteten Auflageflächen 14a, 14'a versehen.

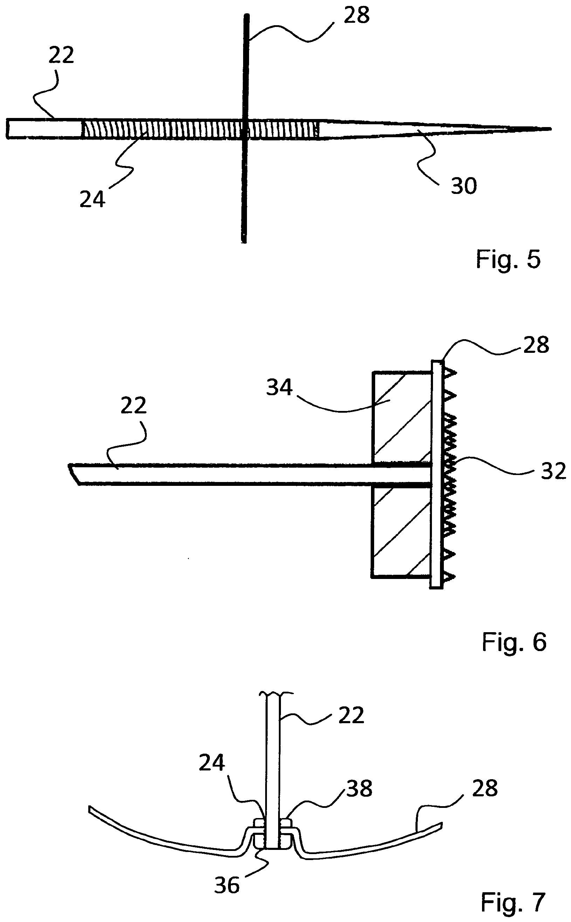

In Fig. 5 ist eine erste Ausführungsform für die Art der Befestigung der Bodenstützen 2, 2a im Untergrund dargestellt. Es ist nur der untere Bereich der Bodenstütze 2, 2a mit dem unteren Teil des Stabes 22, 22a gezeigt, was durch eine Schnittlinie angedeutet ist. Auch hier ist ein Teilbereich mit einem Außengewinde 24 versehen, sofern der Stab 22 als Ganzes keine Gewindestange ist. Auf dem Außengewinde 24 ist ein Teller 28 aufgeschraubt, der hierzu ein zentrales Loch mit einem zum Außengewinde 24 des Stabbereichs komplementären Innengewinde aufweist. Über die vertikale Stellung des Tellers 28 wird die über dem Teller 28 liegende freie Länge des Stabes 22 definiert. Damit wird automatisch das Niveau des oberen Außengewindes 24, an welchem die Auflageplatten 4, 4a angebracht sind, bestimmt. Soll das Niveau tiefer liegen, muss der Stab 22 lediglich tiefer in den Untergrund 8 eingetrieben werden. Das Ende des Stabes 22 wird von einer Spitze oder einem Dorn 30 gebildet, der das Eintreiben erleichtert.

Fig. 6 zeigt eine Variante hierzu, bei der anstelle des Dorns 30 (oder auch zusätzlich zu diesem) die Unterseite des Tellers 28 mit einer Antirutschstruktur, wie beispielsweise einer Vielzahl an Spikes 32 versehen ist. Um einen höheren Anpressdruck zu erreichen, als dieser durch das Eigengewicht der Bodenstütze 2, 2a mit der Last der Photovoltaikmodule 6 vorliegt, kann es zweckmäßig sein, ein zusätzliches Belastungsgewicht 34 auf der Oberseite des Tellers 28 zu platzieren.

In Fig. 7 ist eine weitere alternative Ausführung dargestellt. Der Teller 28 ist in dieser Ausführung an seinen Rändern schalenartig nach oben gebogen, wodurch eine kippbare Lagerung des Haltesystems 1 realisiert ist. Das Außengewinde 24 des Stabes 22 greift in ein zentrales Loch des Tellers 28 ein und ist an seinem untergrundseitigen Ende, das heißt auf der Tellerunterseite mit einer Haltemutter 36 verschraubt. Für einen betriebssicheren Halt ist auf der Telleroberseite eine Kontermutter 38 auf das Außengewinde 24 geschraubt, sodass der Teller 28 kraftschlüssig mittels der Haltemutter 36 und der Kontermutter 38 am Stab 22 gehalten wird.

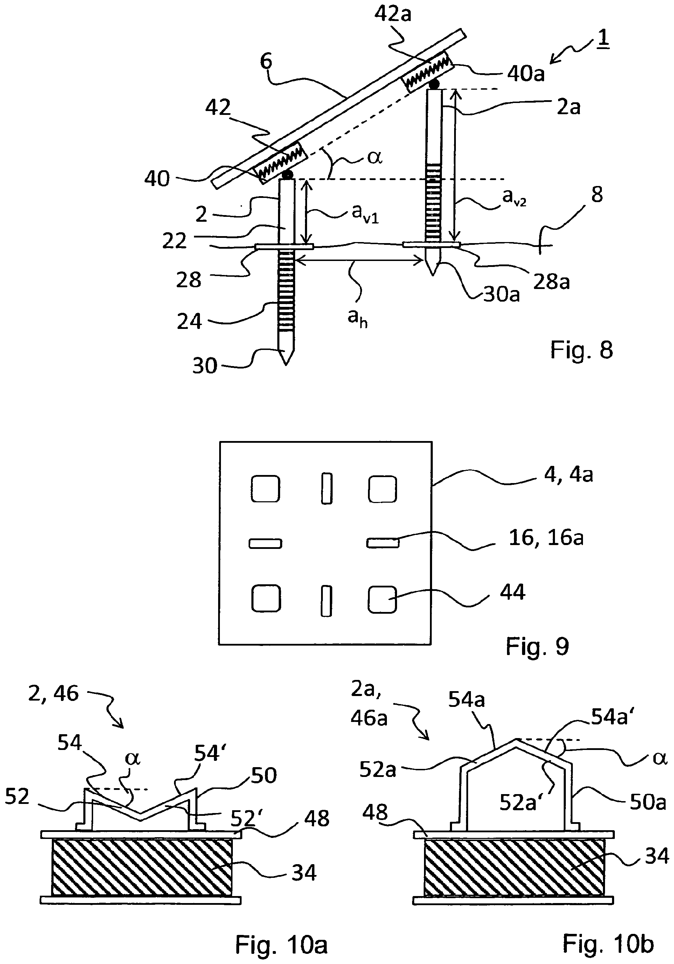

In Fig. 8 ist die geometrische Beziehung zwischen dem Neigungswinkel $\alpha$, dem vergleichsweise geringen vertikalen Abstand $a_{v1}$ der Anbindungsstelle der ersten Bodenstütze 2 zum Untergrund 8, dem vergleichsweise große vertikalen Abstand $a_{v2}$ der Anbindungsstellen der zweiten Bodenstütze 2a zum Untergrund 8 und dem horizontalen Abstand $a_h$ zwischen den Anbindungsstellen des Bodenstützenpaares veranschaulicht. Die Bodenstützen 2, 2a der Reihen 10, 10a sind einerseits in deren horizontalem Abstand $a_h$, und andererseits in deren vertikalem Niveaus $a_{v1}$ und $a_{v2}$ derart bemessen, dass die Beziehung gilt: $a_{v2} = a_{v1} + a_h \cdot \tan \alpha$.

Die Auflageplatten 4, 4a sind in der in Fig. 8 dargestellten Ausführung mit einer sägezahnartigen Haltekontur 40, 40a versehen, welche im Montagezustand in eine komplementäre Gegenkontur 42, 42a an der Unterseite eines montierten Photovoltaikmoduls 6 eingreifen und dadurch einen rutschsicheren Halt realisieren.

Fig. 9 zeigt in Aufsicht die Auflageplatten 4, 4a in einer Ausführung mit vier Polstern 44, die in jeweils einem Eckbereich der im Wesentlichen quadratischen Auflageplatte 4, 4a angeordnet sind. Die Polster 44 sind als ein weiches und elastisches Kunststoffkissen ausgeführt. Dadurch werden die Ecken eines montierten Photovoltaikmoduls 6 bei Krafteinwirkung, beispielsweise während der Montage oder Wartung, auf die Photovoltaikmoduloberfläche entlastet.

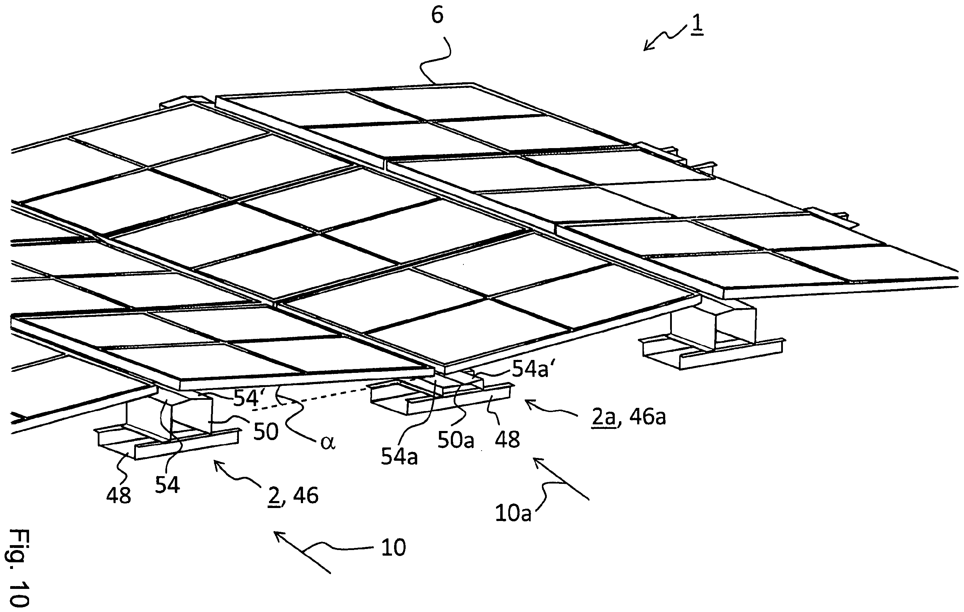

In den Fig. 10, 10a und 10b ist ein drittes Anordnungsbeispiel gezeigt, wobei die Bodenstützen 2, 2a nicht in Form von Stäben 22, sondern mit metallischen Trägersystemen 46, 46a ausgeführt sind. Die Trägersysteme 46, 46a sind gebildet aus einer auf dem Untergrund 8 aufliegenden, im Wesentlichen U-förmigen Beschwerungswanne 48 und einem dazu 90° gedrehten Auflageträger 50, 50a.

Die Beschwerungswanne 48 liegt mit deren horizontalen U-Schenkel auf dem Untergrund 8 auf und ist - wie in den Fig 10a und 10b erkennbar - dazu geeignet und eingerichtet, ein Beschwerungsgewicht 34 aufzunehmen. Die vertikalen U-Schenkel der länglichen Beschwerungswanne 48 sind senkrecht zu den Reihen 10, 10a orientiert.

Die Auflageträger 50, 50a sind im Wesentlichen ebenfalls U-förmig ausgeführt, wobei die horizontalen U-Schenkel nach Art der Auflageplatten 4, 4a ausgeführt sind. Die vertikalen U-Schenkel der Auflageträger 50, 50a sind senkrecht zu den Beschwerungswannen 48 orientiert, das heißt im Wesentlichen parallel zu den Reihen 10, 10a. Die vertikalen U-Schenkel der Auflageträger 50, 50a setzen auf denen der Beschwerungswannen 48 auf und sind mittels einer Schweißnaht miteinander verbunden.

Der horizontale U-Schenkel des auf dem tieferen Niveau befindlichen Auflageträgers 48 weist zwei Abkantungen 52, 52' auf, durch welche bei dem Auflageträger 50 zwei Auflageflächen 54, 54' gebildet werden. Die Abkantungen 52, 52' sind nach oben gerichtet, das heißt, dass auch die Auflageflächen 54, 54' nach oben weisen, vorzugsweise mit dem Winkel $\alpha$ zur Horizontalen, der die gewünschte Neigung der Photovoltaikmodule 6 zum Untergrund 8 festlegt. Entsprechend sind in Abänderung zu der in der Fig. 10a gezeigten Bodenstütze 2 die Abkantungen 52a, 52a'des zweiten Auflageträgers 50a unter dem Winkel $\alpha$ nach unten gerichtet. Die durch die Abkantungen 52a, 52a' gebildeten Auflageflächen 54a und 54a' weisen also nach unten hin zu den komplementären Auflageflächen 54, 54' des Auflageträgers 50 der ersten Bodenstütze 2, so dass alle Auflageflächen 54, 54a, die ein und dasselbe Photovoltaikmodul 6 halten, in einer gemeinsamen Ebene liegen.

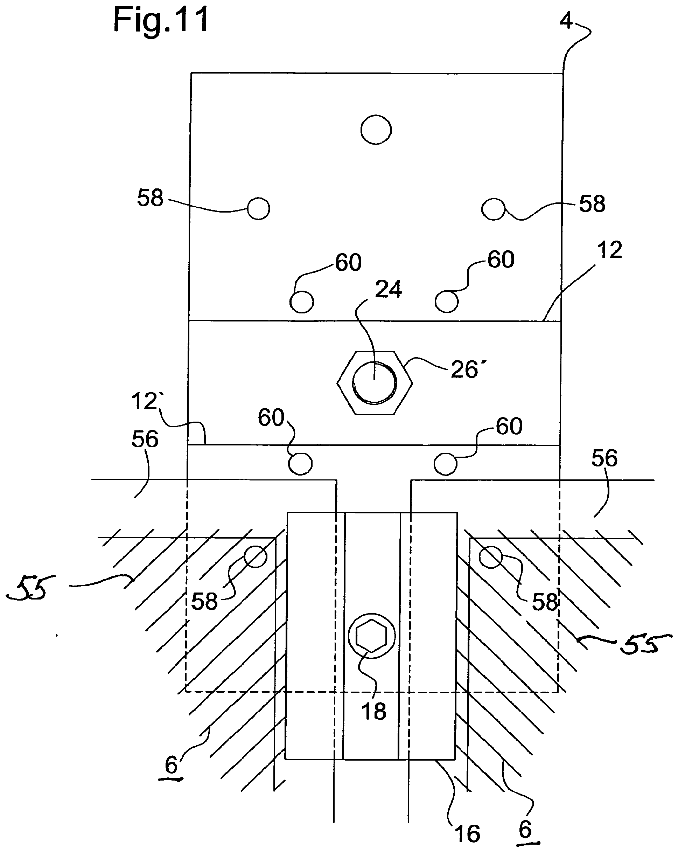

In Fig. 11 ist eine Aufsicht auf die Auflageplatte 4 gemäß Fig. 3 sowie auf die Eckbereiche von zwei ausschnittsweise gezeigten Photovoltaikmodule (PV-Modul) 6 mit deren in Schraffur veranschaulichten Glasflächen 55 dargestellt. Die jeweilige Glasfläche 55 wird im Randbereich des PV-Moduls 6 von einem Modulrahmen 56 des jeweiligen PV-Moduls 6 teilweise überdeckt. Im Bereich der Auflageflächen 14, 14' der Auflageplatte 4 sind Montagestifte 58 vorgesehen, die sich ausgehend von den Abkantungen 12, 12' der Auflageplatte 4 vertikal nach oben erstrecken. Je Abkantung 12, 12' bzw. je Auflagefläche 14 bzw. 14' sind vorzugsweise mindestens zwei Montagehilfsstifte 58 vorgesehen. Auch können weitere Montagehilfsstifte 60 vorgesehen sein, die dann vorzugsweise ebenfalls im Eckbereich des PV-Moduls 6, jedoch außerhalb des Modulrahmens 56 auf der jeweiligen Auflagefläche 14, 14' positioniert sind.

Die Montagehilfsstifte 58 weisen eine über die Abkantung 12,12' hinausragende vertikale Länge von ca. 3mm bis 8mm auf. Sie sind vorzugsweise mit einem scharfen oberen Rand versehen, der ein zuverlässiges Verhaken mit der unteren Kante des Modulrahmens 56 ermöglicht, damit dieser nicht über den Montagehilfsstift 58 hinweg gleiten kann. Die Montagehilfsstifte 58 sind derart angeordnet, dass diese am inneren Rand des Modulrahmens 56 anliegen können. Im gezeigten Fall einer Eckmontage der PV-Module 6 befinden sich die Montagehilfsstifte 58 innerhalb des Modulrahmens 56 im Eckbereich der jeweiligen Glasfläche 55. Bei der Montage eines Photovoltaikfeldes werden die PV-Module 6 einzeln oder in Gruppen zunächst auf die Auflageplatten 4, 4a abgelegt, von denen sie aufgrund der Montagehilfsstifte 58, 60 nicht abgleiten und auf denen sie allenfalls nur geringfügig verrutschen können. Anschließend werden die einzelnen PV-Module 6 ausgerichtet und mittels der Modulklammern 16 fixiert.

Bezugszeichenliste

| | |
|---|---|
| 1 | Haltessystem |
| 2, 2a | Bodenstütze |
| 4, 4a | Auflageplatte |
| 6 | Photovoltaikmodul |
| 8 | Untergrund |
| 10, 10a | Reihe |
| 12, 12', 12a, 12a' | Abkantung |
| 14, 14', 14a, 14a' | Auflagefläche |
| 16 | Modulklammer |
| 18 | Schraube |
| 20 | Zentrierstift |
| 22 | Stab |
| 24 | Außengewinde |
| 26, 26' | Mutter |
| 28 | Teller |
| 30 | Dorn |
| 32 | Spikes |
| 34 | Belastungsgewicht |
| 36 | Haltemutter |
| 38 | Kontermutter |
| 40, 40a | Haltekontur |
| 42, 42a | Gegenkontur |
| 44 | Polster |
| 46, 46a | Trägersystem |
| 48 | Beschwerungswanne |
| 50, 50a | Auflageträger |
| 52, 52', 52a, 52a' | Abkantung |
| 54, 54', 54a, 54a' | Auflagefläche |
| 55 | Glasfläche |
| 56 | Modulrahmen |
| 58,60 | Montagehilfsstift |
| $\alpha$ | Neigungswinkel |
| V | Versatz |
| $a_{v1}$, $a_{v2}$ | vertikaler Abstand |
| $a_h$ | horizontaler Abstand |

**Patentansprüche**

1. Halterungssystem (1) zur Montage eines Photovoltaikmoduls (6) über einem Untergrund (8) mittels Bodenstützen (2, 2a, 46, 46a), die eine Auflageplatte (4, 4a, 50, 50a) für das Photovoltaikmodul (6), einen Bodenstützenkörper (22) und eine untergrundseitige Untergrundfläche (28, 48) aufweisen, die einem Eindringen der Bodenstützen (2, 2a, 46, 46a) in den Untergrund (8) entgegenwirkt,

   - wobei die Untergrundfläche (28, 48) und die Auflageplatte (4, 4a, 50, 50a) jeder Bodenstütze (2, 2a, 46, 46a) über den Bodenstützenkörper (22, 50, 50a) miteinander verbunden sind,
   - wobei die Auflageplatten (4, 4a, 50, 50a) eine in einem Neigungswinkel ($\alpha$) gegen den Untergrund (8) schräg gestellte Auflagefläche (14, 14', 14a, 14a', 54, 54', 54a, 54a') aufweisen und
   - wobei die Bodenstützen (2, 2a, 46, 46a) dazu vorgesehen und eingerichtet sind, dass im Montagezustand die Auflageflächen (14, 14', 14a, 14a', 54, 54', 54a, 54a') eines Bodenstützenpaares (2, 2a, 46, 46a) zum Untergrund (8) vertikal und in Anpassung an das Photovoltaikmodul (6) zueinander horizontal beabstandet sind sowie miteinander zumindest im Wesentlichen fluchten
   - **dadurch gekennzeichnet,**
   - **dass** die Auflageplatte (4, 50) der ersten Bodenstütze (2) des Bodenstützenpaares (2, 2a, 46, 46a) für die Auflage des Randes eines oder mehrerer Photovoltaikmodule (6) vorgesehen ist und an gegenüberliegenden Seiten jeweils eine unter dem Winkel ($\alpha$) nach oben weisende Abkantung (12, 12', 52, 52') aufweist, als deren Folge die nach oben gerichtete Auflagefläche (14, 14', 54, 54') gebildet wird, und
   - **dass** die Auflageplatte (4a, 50a) am kopfseitigen Ende der zweiten Bodenstütze (2a) des Bodenstützenpaares (2, 2a, 46, 46a) eine Auflagefläche (14a, 14a', 54a, 54a') für den Rand eines oder mehrerer Photovoltaikmodule (6) aufweist, die an gegenüberliegenden Seiten jeweils eine unter dem Winkel ($\alpha$) nach unten weisende Abkantung (12a, 12a', 52a, 52a') aufweist, als deren Folge die nach unten gerichtete Auflagefläche (14a, 14a', 54a, 54a') gebildet wird.

2. Halterungssystem (1) nach Anspruch 1, **dadurch gekennzeichnet,**
   **dass** die Auflageflächen (14, 14', 14a, 14a', 54, 54', 54a, 54a') eine Haltestruktur (40, 40a) aufweisen, die dazu vorgesehen und eingerichtet ist, im Montagezustand mit einer komplementären Gegenstruktur (42, 42a) an der Unterseite des Photovoltaikmoduls (6) zu verzahnen.

3. Halterungssystem (1) nach Anspruch 1 oder 2,
   **dadurch gekennzeichnet,**
   **dass** die Auflageflächen (14, 14', 14a, 14a', 54, 54', 54a, 54a') dazu vorgesehen und eingerichtet sind, die Photovoltaikmodule (6) durch Verklebung oder Klemmfixierung zu halten.

4. Halterungssystem (1) nach einem der Ansprüche 1 bis 3,
   **dadurch gekennzeichnet,**
   **dass** jede Auflagefläche (14, 14', 14a, 14a', 54, 54', 54ä, 54a') mit einem Gewindeloch für die Aufnahme einer Modulklammer (16) und mit einem nach oben weisenden Zentrierstift (20) versehen ist, der dazu vorgesehen und eingerichtet ist, im Montagezustand in eine kongruente Aussparung in einem Rahmen des Photovoltaikmoduls (6) einzugreifen.

5. Halterungssystem (1) nach einem der Ansprüche 1 bis 4,
   **dadurch gekennzeichnet,**
   **dass** der stabförmige Bodenstützenkörper (22) zumindest in einem kopfseitigen Teilbereich ein Außengewinde (24) aufweist, welches mit einem zentralen Loch mit Innengewinde fluchtet, welches zwischen den jeweils gegenüberliegenden Abkantungen (12, 12', 12a, 12a', 52, 52', 52a, 52a') der Auflageplatte (4, 4a, 50, 50a) angeordnet ist.

6. Halterungssystem (1) nach Anspruch 5,
   **dadurch gekennzeichnet,**
   **dass** der stabförmige Bodenstützehkörper (22) zumindest in einem unteren Teilbereich ein Außengewinde (24) aufweist, welches mit einem zentralen Loch mit Innengewinde fluchtet, welches im Zentrum der tellerartigen Untergrundfläche (28) angeordnet ist.

7. Halterungssystem (1) nach einem der Ansprüche 1 bis 6,
   **dadurch gekennzeichnet,**
   **dass** im Montagezustand die Anbindungsstellen zwischen der jeweiligen Auflagefläche (14, 14', 14a, 14a', 54, 54', 54a, 54a') und dem jeweiligen Bodenstützenkörper (22, 48, 50) einer ersten Bodenstütze (2, 46) und der zweiten Bodenstütze (2a, 46a) des Bodenstützenpaares (2, 2a, 46, 46a) gemäß der Beziehung

$$a_{v2} = a_{v1} + a_h \cdot \tan \alpha$$

beabstandet sind, wobei $\alpha$ der Neigungswinkel, $a_{v1}$ der vergleichsweise geringe vertikale Abstand der Anbindungsstelle der ersten Bodenstütze (2, 46) zum Untergrund, $a_{v2}$ der vergleichsweise große vertikale Abstand der Anbindungsstellen der zweiten Bodenstütze (2a, 46a) zum Untergrund (8) und $a_h$ der horizontale Abstand zwischen den Anbindungsstellen des Bodenstützenpaares (2, 2a, 46, 46a) ist.

8. Halterungssystem (1) nach einem der Ansprüche 1 bis 7,
**dadurch gekennzeichnet,**
**dass** die Auflageflächen (14, 14', 14a, 14a', 54, 54', 54a, 54a') aus einem biegsamen Material gefertigt und dazu vorgesehen und eingerichtet sind, eine durch unterschiedliches Eindringen der Bodenstütze (2, 2a, 46, 46a) in den Untergrund (8) hervorgerufene Torsion innerhalb der jeweiligen Auflageplatte (4, 4a) aufzunehmen.

9. Halterungssystem (1) nach einem der Ansprüche 1 bis 8,
**dadurch gekennzeichnet,**
**dass** die Unterseite der Untergrundfläche (28, 48) mit einer Antirutschstruktur (32) versehen ist, und/oder dass auf den Untergrundflächen (28, 48) ein Belastungsgewicht (34) vorgesehen ist.

10. Halterungssystem (1) nach einem der Ansprüche 1 bis 9,
**dadurch gekennzeichnet,**
**dass** der Abstand ($a_{v1}$, $a_{v2}$) zwischen der Untergrundfläche (28, 48) und der Auflageplatte (4, 4a, 50, 50a) zwischen 30cm und 100cm, insbesondere zwischen 40cm und 80cm, vorzugsweise zwischen 50cm und 60cm, beträgt.

11. Halterungssystem (1) nach einem der Ansprüche 1 bis 10,
**dadurch gekennzeichnet,**
**dass** die Auflageflächen (14, 14', 14a, 14a', 54, 54', 54a, 54a') in mindestens einem Eckbereich ein Polster (44) aufweisen, wobei die Größe der Auflageflächen (14, 14', 14a, 14a', 54, 54', 54a, 54a') derart bemessen ist, dass im Montagezustand das Polster (44), vorzugsweise vollständig, unter einem montierten Photovoltaikmodul (6) liegt.

12. Halterungssystem (1) nach einem der Ansprüche 1 bis 11,
**dadurch gekennzeichnet,**
**dass** der Bodenstützenkörper (22) stab- oder U-förmig und/oder die Untergrundfläche (28) tellerartig mit unterseitig einem in den Untergrund eintreibbarer Dorn (30) ist.

13. Halterungssystem (1) nach einem der Ansprüche 1 bis 12,
**dadurch gekennzeichnet,**
**dass** der Rand der tellerartigen Untergrundfläche (28) schalenartig vertikal nach oben gebogen ist.

14. Photovoltaikanlage mit einer Vielzahl von Photovoltaikmodulen (6) und mit einem Halterungssystemen (1) nach einem der Ansprüche 1 bis 13,
**dadurch gekennzeichnet,**

- **dass** die ersten Bodenstützen (2, 46) und die zweiten Bodenstützen (2a, 46a) jeweils eine Mehrzahl von parallel zueinander verlaufenden Reihen (10, 10a) bilden, und
- **dass** zwischen zwei Reihen von ersten Bodenstützen (10) eine Reihe von zweiten Bodenstützen (10a) angeordnet ist.

15. Photovoltaikanlage nach Anspruch 14,
**dadurch gekennzeichnet,**
**dass** die Reihen (10) mit ersten Bodenstützen (2, 46) versetzt sind zu den Reihen (10) mit zweiten Bodenstützen (2a, 46a) derart, dass bei montierten Photovoltaikmodulen (6) mit Ausnahme randseitiger Photovoltaikmodule (6) jedes Photovoltaikmodul (6) an insgesamt drei Auflageplatten (4, 4a, 50, 50a) befestigt ist.

**Claims**

1. Holding system (1) for mounting a photovoltaic module (6) above a ground (8) by means of base supports (2, 2a, 46, 46a), which comprise a support plate (4, 4a, 50, 50a) for the photovoltaic module (6), a base support body (22) and a ground-side supporting surface (28, 48), which counteracts the penetration of the base supports (2, 2a, 46, 46a) into the ground (8),

   - wherein the supporting surface (28, 48) and the support plate (4, 4a, 50, 50a) of each base support (2, 2a, 46, 46a) are respectively connected to one another via the base support bodies (22, 50, 50a),
   - wherein the support plates (4, 4a, 50, 50a) comprise a support surface (14, 14', 14a, 14a', 54, 54', 54a, 54a') which is inclined at an angle ($\alpha$) with respect to the ground (8), and
   - wherein the base supports (2, 2a, 46, 46a) are so provided and arranged in the mounting position that the support surfaces (14, 14', 14a, 14a', 54, 54', 54a, 54a') of a base support pair (2, 2a, 46, 46a) are vertical with respect to the ground (8) and are horizontally spaced apart from each other in adaptation to the photovoltaic module (6) and are at least substantially aligned with one another.

   **characterized in that**
   the support plate (4, 50) of the first base support (2) of the base support pair (2, 2a, 46, 46a) is provided to support the edge of one or more photovoltaic modules (6), and comprises angled surfaces (12, 12', 52, 52') on opposing sides and respectively bent upwards at an angle ($\alpha$), as a result of which the upwardly-directed support surface (14, 14', 54, 54') is formed, and
   wherein the support plate (4a, 50a) comprises a support surface (14a, 14a', 54a, 54a') at the head-side end of the second of the supports (2a) of the base support pair (2, 2a, 46, 46a) for the edge of one or more photovoltaic modules (6), which comprises angled surfaces (12, 12', 52, 52') on opposing sides respectively bent downwards at an angle ($\alpha$), as a result of which the downwardly-directed support surface (14, 14', 54, 54') is formed.

2. Holding system (1) according to claim 1,
   **characterized in that**
   the support surfaces (14, 14', 14a, 14a', 54, 54', 54a, 54a') comprise a holding structure (40, 40a) which is provided and arranged in the mounted state to interlock with a complementary counter-structure (42, 42a) on the underside of the photovoltaic module (6).

3. Holding system (1) according to claim 1 or 2,
   **characterized in that**
   the support surfaces (14, 14', 14a, 14a', 54, 54', 54a, 54a') are provided and arranged to hold the photovoltaic modules (6) by adhesion or clamp fixing.

4. Holding system (1) according to one of the claims 1 to 3,
   **characterized in that**
   each support surface (14, 14', 14a, 14a', 54, 54', 54a, 54a') is provided with a threaded hole to receive a module clamp (16) and with an upwardly-directed centering pin (20), which is provided and arranged in the mounted state to engage a congruent recess in a frame of the photovoltaic module (6).

5. Holding system (1) according to one of claims 1 to 4,
   **characterized in that**
   the rod-shaped base support body (22) comprises at least one external thread (24) in a head-side section, which is aligned with a central hole with an internal thread, which is arranged between the respective opposing angled surfaces (12, 12'', 12a, 12a', 52, 52', 52a, 52a') of the support plate (4, 4a, 50, 50a).

6. Holding system (1) according to claim 5;
   **characterized in that**
   the rod-shaped base support body (22) comprises, at least one external thread (24) in a lower section, which is aligned with a central hole with an internal thread arranged in the center of the plate-like support surface (28);

7. Holding system (1) according to one of the claims 1 to 6,
   **characterized in that,**
   in the mounted state, the connection points between the respective support surface (14, 14', 14a, 14a', 54, 54', 54a, 54a') and the respective base support body (22, 48, 50), a first base support (2, 46) and the second base support (2a, 46a) of the base support pair (2, 2a, 46, 46a) are spaced apart according to the relationship:

$$a_{v2} = a_{v1} + a_h \cdot \tan \alpha$$

wherein $\alpha$ is the angle of inclination, $a_{v1}$ is the comparatively small vertical distance of the connection point of the first base support (2, 46) to the ground, $a_{v2}$ is the comparatively large vertical distance between the connection points of the second base support (2a, 46a) to the ground (8), and $a_h$ is the horizontal distance between the connection points of the base support pair (2, 2a, 46, 46a).

8.  Holding system (1) according to one of the claims 1 to 7,
    **characterized in that**
    the support surfaces (14, 14', 14a, 14a', 54, 54', 54a, 54a') are made of a flexible material and are provided and arranged to absorb within the respective support plate (4, 4a), the torsion generated in the ground (8) through different penetration of the base support (2, 2a, 46, 46a).

9.  Holding system (1) according to one of claims 1 to 8,
    **characterized in that,**
    the underside of the support surface (28, 48) is provided with an anti-slip structure (32), and/or the support surface (28, 48) is provided with a ballast weight (34).

10. Holding system (1) according to one of claims 1 to 9,
    **characterized in that**
    the distance ($a_{v1}$, $a_{v2}$) between the support surface (28, 48) and the base plate (4, 4a, 50, 50a) lies between 30 cm and 100 cm, preferably between 40 cm and 80 cm, in particular between 50 cm and 60 cm.

11. Holding system (1) according to one of claims 1 to 10,
    **characterized in that**
    the support surfaces (14, 14', 14a, 14a', 54, 54', 54a, 54a') comprise a cushion (44) in at least one corner area, wherein the support surface (14, 14', 14a, 14a', 54, 54', 54a, 54a') is dimensioned so that in the mounted state, the cushion (44) preferably lies completely under a mounted photovoltaic module (6).

12. Holding system (1) according to one of the claims 1 to 11,
    **characterized in that**
    the base support body (22) is rod-shaped or U-shaped and/or the base surface (28) is plate-like with a mandrel (30) which may be driven into the ground.

13. Holding system (1) according to one of the claims 1 to 12,
    **characterized in that**
    the edge of the plate-like sub-surface (28) is bent vertically upwards like a shell.

14. Photovoltaic system with a plurality of photovoltaic modules (6) and with a holding system (1) according to one of the claims 1 to 13,
    **characterized in that**

    - the first base supports (2, 46) and the second base supports (2a, 46a) each form a plurality of rows (10, 10a) running parallel to one another, and
    - a row of second base supports (10a) is arranged between two rows of first base supports (10).

15. Photovoltaic system according to claim 14,
    **characterized in that**
    the rows (10) with first base supports (2, 46) are offset with respect to the rows (10) with second base supports (2a, 46a) in such a way that in the case of the mounted photovoltaic modules (6), with the exception of edge-side photovoltaic modules (6), each photovoltaic module (6) is fastened to a total of three support plates (4, 4a; 50; 50a).

**Revendications**

1. Système de support (1) pour le montage d'un module photovoltaïque (6) au-dessus d'un sol (8) au moyen de supports (2, 2a, 46, 46a), qui comprennent une plaque d'appui (4, 4a, 50, 50a) pour le module photovoltaïque (6), un corps de support (22) et une surface de fond (28, 48) côté sol, qui empêche une pénétration des supports (2, 2a, 46, 46a) dans le sol (8),

   - la surface de fond (28, 48) et la plaque d'appui (4a, 4a, 50, 50a) de chaque support (2, 2a, 46, 46a) étant reliées entre elles par l'intermédiaire du corps de support (22, 50, 50a)
   - les plaques d'appui (4, 4a, 50, 50a) comprenant une surface d'appui (14, 14', 14a, 14a', 54, 54', 54a, 54a') disposée de manière inclinée avec un angle d'inclinaison ($\alpha$) par rapport au sol (8) et
   - les supports (2, 2a, 46, 46a) étant prévus et conçus de façon à ce que, dans l'état de montage, les surfaces d'appui (14, 14', 14a, 14a', 54, 54', 54a, 54a') d'une paire de supports (2, 2a, 46, 46a) soient disposées verticalement par rapport au sol (8) et horizontalement entre elles en s'adaptant au module photovoltaïque (6) et sont ainsi alignées au globalement entre elles, **caractérisé en ce que**
   - la plaque d'appui (4, 50) du premier support (2) de la paire de supports (2, 2a, 46, 46a) est prévue pour l'appui du bord d'un ou de plusieurs modules photovoltaïques (6) et comprend, sur chacun des côtés opposés, un pli (12, 12', 52, 52') orienté vers le haut avec un angle ($\alpha$), dont la succession constitue la surface d'appui (14, 14', 54, 54') orientée vers le haut et
   - la plaque d'appui (4a, 50a) comprend, au niveau de l'extrémité, du côté de la tête, du deuxième support (2a) de la paire de supports (2, 2a, 46, 46a), une surface d'appui (14a, 14a', 54a, 54a') pour le bord d'un ou plusieurs modules photovoltaïques (6), qui comprend, sur chacun des côtés opposés un pli (12a, 12a', 52a, 52a') orienté vers le bas avec un angle ($\alpha$), dont la succession constitue la surface d'appui (14a, 14a', 54a, 54a') orientée vers le bas.

2. Système de support (1) selon la revendication 1, **caractérisé en ce que**
   les surfaces d'appui (14, 14', 14a, 14a', 54, 54', 54a, 54a') comprennent une structure de maintien (40, 40a) qui est prévue et conçue pour s'engrener, dans l'état de montage, avec une structure complémentaire (42, 42a) sur le côté inférieur du module photovoltaïque (6).

3. Système de support (1) selon la revendication 1 ou 2, **caractérisé en ce que**
   les surfaces d'appui (14, 14', 14a, 14a', 54, 54', 54a, 54a') sont prévues et conçues pour maintenir les modules photovoltaïques (6) par collage ou serrage.

4. Système de support (1) selon l'une des revendications 1 à 3, **caractérisé en ce que**
   chaque surface d'appui (14, 14', 14a, 14a', 54, 54', 54a, 54a') est munie d'un trou fileté pour le logement d'une chambre de module (16) et d'une tige de centrage (20) orientée vers le haut, qui est prévue et conçue pour s'emboîter, dans l'état de montage, dans un évidement congruent dans un cadre du module photovoltaïque (6).

5. Système de support (1) selon l'une des revendications 1 à 4, **caractérisé en ce que**
   le corps de support (22) en forme de tige comprend au moins dans une partie côté tête un filetage externe (24) qui est aligné avec un trou central avec un filetage interne, qui se trouve entre les plis opposés (12, 12', 12a, 12a', 52, 52', 52a, 52a') de la plaque d'appui (4a, 4a, 50, 50a).

6. Système de support (1) selon la revendication 5, **caractérisé en ce que**
   le corps de support (22) en forme de tige comprend au moins dans une partie inférieure un filetage externe (24) qui est disposé au centre de la surface de fond (28) en forme d'assiette.

7. Système de support (1) selon l'une des revendications 1 à 6, **caractérisé en ce que**
   dans l'état de montage, les points de liaison entre la surface d'appui (14, 14', 14a, 14a', 54, 54', 54a, 54a') et le corps de support (22, 48, 50) correspondant, d'un premier support (2, 46) et du deuxième support (2a, 46a) de la paire de supports (2, 2a, 46, 46a) sont espacés selon la relation :

$$a_{v2} = a_{v1} + a_h * \tan \alpha$$

$\alpha$ étant l'angle d'inclinaison, $a_{v1}$ étant la distance verticale relativement faible entre le point de liaison du premier support (2, 46) et le sol, $a_{v2}$ est la distance verticale relativement importante entre les points de liaison du deuxième support (2a, 46a) avec le sol (8) et $a_h$ étant la distance horizontale entre les points de liaison de la paire de supports (2, 2a, 46, 46a).

8. Système de support (1) selon l'une des revendications 1 à 7, **caractérisé en ce que**
les surfaces d'appui (14, 14', 14a, 14a', 54, 54', 54a, 54a') sont constituées d'un matériau flexible et prévues et conçues pour absorber une torsion à l'intérieur de la plaque d'appui (4, 4a) provoquée par la pénétration différente du support (2, 2a, 46, 46a) dans le sol (8).

9. Système de support (1) selon l'une des revendications 1 à 8, **caractérisé en ce que**
le côté intérieur de la surface de fond (28, 48) est muni d'une structure antidérapante (32) et/ou **en ce que**, sur les surfaces de fond (28, 48), est prévu un poids de lestage (34).

10. Système de support (1) selon l'une des revendications 1 à 9, **caractérisé en ce que**
la distance ($a_{v1}$, $a_{v2}$) entre la surface de fond (28, 48) et la plaque d'appui (4, 4a, 50, 50a) est entre 30 cm et 100 cm, plus particulièrement entre 40 cm et 80 cm, de préférence entre 50 cm et 60 cm.

11. Système de support (1) selon l'une des revendications 1 à 10, **caractérisé en ce que**
les surfaces d'appui (14, 14', 14a, 14a', 54, 54', 54a, 54a') comprennent, dans au moins une zone d'angle, une garniture (44), la taille des surfaces d'appui (14, 14', 14a, 14a', 54, 54', 54a, 54a') étant telle que, dans l'état de montage, la garniture (44) se trouve, de préférence entièrement, sous un module photovoltaïque (6) monté.

12. Système de support (1) selon l'une des revendications 1 à 11, **caractérisé en ce que**
le corps de support (22) présente une forme de tige ou de U et/ou la surface de fond (28) présente la forme d'une assiette avec une broche (30) pouvant être enfoncée dans le sol.

13. Système de support (1) selon l'une des revendications 1 à 12, **caractérisé en ce que**
le bord de la surface de fond (28) en forme d'assiette est plié verticalement vers le haut à la manière d'une coque.

14. Installation photovoltaïque avec une pluralité de modules photovoltaïques (6) et avec un système de support (1) selon l'une des revendications 1 à 13, **caractérisée en ce que**

- les premiers supports (2, 46) et les deuxièmes supports (2a, 46a) forment chacun une pluralité de rangées (10, 10a) parallèles entre elles et
- entre deux rangées de premiers supports (10) se trouve une rangée de deuxièmes supports (10a).

15. Installation photovoltaïque selon la revendication 14, **caractérisée en ce que**
les rangées (10) avec les premiers supports (2, 46) sont décalées par rapport aux rangées (10) avec les deuxièmes supports (2a, 46a) de façon à ce que, lorsque les modules photovoltaïques (6) sont montés, à l'exception des modules photovoltaïque (6) montés sur le bord, chaque module photovoltaïque (6) soit fixé au total sur trois plaques d'appui (4, 4a, 50, 50a).

Fig. 1

Fig. 2

Fig. 1a

Fig. 2a

*Fig. 3*

*Fig. 4*

22

28

24

30

**Fig. 5**

28

34

22

32

**Fig. 6**

22

24

38

28

36

**Fig. 7**

Fig. 8

Fig. 9

Fig. 10a

Fig. 10b

Fig. 10

EP 2 771 913 B1

# Fig.11

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5143556 A1